# EUROPEAN PATENT SPECIFICATION

(11) **EP 3 096 592 B1**
(45) Date of publication and mention of the grant of the patent: **04.09.2024**
(21) Application number: 15737145.1
(22) Date of filing: 14.01.2015
(51) Int. Cl.: H05K 3/34, H05K 1/02, H05K 3/10, H05K 3/00, H05K 3/18

(54) **THREE-DIMENSIONAL CIRCUIT BOARD AND METHOD OF FORMING A THREE-DIMENSIONAL CIRCUIT BOARD**
DREIDIMENSIONALE LEITERPLATTE UND VERFAHREN ZUR HERSTELLUNG EINER DREIDIMENSIONALEN LEITERPLATTE
CARTE À CIRCUIT IMPRIMÉ TRIDIMENSIONNEL ET PROCÉDÉ DE FORMATION D'UNE CARTE À CIRCUIT IMPRIMÉ TRIDIMENSIONNEL

(30) Priority: 14.01.2014 JP 2014004548
(43) Date of publication of application: 23.11.2016
(73) Proprietor: TAIYO HOLDINGS CO., LTD., Saitama 355-0222 (JP)
(72) Inventor: SHIMAMIYA, Ayumu, Hiki-gun Saitama 355-0222 (JP); YONEDA, Naoki, Hiki-gun Saitama 355-0222 (JP); USHIKI, Shigeru, Hiki-gun Saitama 355-0222 (JP)
(74) Representative: Hoffmann Eitle
(86) International application number: PCT/JP2015/050843
(87) International publication number: WO 2015/108085

(56) References cited:
- WO-A1-2011/093934
- WO-A2-03/005784
- JP-A- 2002 001 209
- JP-A- 2002 001 209
- JP-A- 2003 338 675
- JP-A- 2003 338 675
- JP-A- 2004 534 408
- JP-A- 2004 534 408
- JP-A- 2013 518 180
- JP-A- 2013 518 180
- JP-A- H11 163 197
- JP-A- H11 251 348
- US-A1- 2008 118 681

## Description

### TECHNICAL FIELD

The present invention relates to a three-dimensional circuit board and a method of forming a three-dimensional circuit board, and particularly to a highly reliable three-dimensional circuit board which can prevent solder flow during component mounting or a short in a circuit.

### BACKGROUND ART

As an electronic apparatus such as a cellular phone or a copying machine is miniaturized and multifunctionalized, a circuit board is required to be compactly accommodated inside or outside a casing. A three-dimensional circuit board, in which a conductive wiring is formed on a casing or an electronic component not in a two-dimensional manner but in a three-dimensional manner, is excellent in space efficiency, improvement of the design, reduction in the number of components due to integration of a component and a circuit, or the like. There are a variety of manufacturing methods of a three-dimensional circuit board, and although a circuit board which is formed, for example, by bending a flexible circuit board to be mounted or the like is used, such a circuit board requires labor and cost, and has a limitation in increasing the density of the circuit. Accordingly, methods of forming a circuit directly on a molded three-dimensional board have been proposed.

For example, Patent Document 1 proposes a method of forming a circuit with plating by performing physical masking, printing of conductive coating, printing of a paint which accepts plating, or the like; Patent Document 2 proposes a method of forming a circuit by forming a metal thin film on a molded component with an evaporation method or the like and removing an unwanted metal thin film by laser beam irradiation, plating, and etching; and Patent Document 3 proposes a method of forming a circuit on a molded component with a hot stamping method using metal foil. In recent years, a method of forming a circuit on a three-dimensional board by dispersing a non-conductive metal complex in a resin for molding, molding a three-dimensional board using the resin for molding to be irradiated with a laser beam to generate a metal core, and then performing plating has been often used (Patent Document 4).

Patent Document 5 relates to a main surface of a semiconductor chip provided with an insulating layer which has openings disposed above electrodes and protrusions disposed at anywhere other than the openings, protruding electrodes disposed on the protrusions so as to be connected with an external device, metal wires for connecting the protruding electrodes to pads connected with the electrodes, and a solder resist which is formed so as to cover portions other than the protruding electrodes on the main surface.

Patent Document 6 relates to a coating method.

Patent Document 7 relates to a recess being provided to the rear center of an insulating board.

Patent Document 8 relates to a device for forming a resist layer on a conductive substrate.

Patent Document 9 relates to a method of treating a laser-activated thermoplastic substrate having a metal compound dispersed therein.

Patent Document 10 relates to conductor tracks placed on an electrically non-conductive supporting material, which are comprised of metal nuclei and of a metallization subsequently applied thereto, whereby the metal nuclei are produced by using electromagnetic radiation to break up electrically non-conductive metal compounds contained in the supporting material in a dispersed manner.

Patent Document 11 relates to a method for manufacturing a printed wiring board having a curved insulating substrate.

### RELATED ART DOCUMENTS

### PATENT DOCUMENTS

Patent Document 1: Japanese Unexamined Patent Application Publication No. S63-234603
Patent Document 2: Japanese Unexamined Patent Application Publication No. 2008-53465
Patent Document 3: Japanese Unexamined Patent Application Publication No. 2001-15874
Patent Document 4: Japanese Unexamined Patent Application Publication (Translation of PCT Application) No. 2004-534408
Patent Document 5: JP H11 251348 A
Patent Document 6: JP 2002 001209 A
Patent Document 7: JP H11 163197 A
Patent Document 8: JP 2003 338675 A
Patent Document 9: WO 2011/093934 A1
Patent Document 10: WO 03/005784 A2
Patent Document 11: US 2008/118681 A1

### SUMMARY OF THE INVENTION

### PROBLEMS TO BE SOLVED BY THE INVENTION

Conventionally, a three-dimensional circuit board is practically used merely for a wiring or an antenna. Connection with another component is realized by a contact-type connector, and there has been no particular problem when corrosion of a wiring metal is prevented by gold plating or the like. Due to a greater functionality of a three-dimensional circuit board, a component such as an integrated circuit, for example, an IC (Integrated Circuit), an LED (Light Emitting Diode), a camera, or a microphone, however, has recently been mounted on the three-dimensional circuit board.

Such a component is mounted on a three-dimensional circuit board using a solder. During soldering, a solder flows along a circuit, which reduces the amount of solder with which an electronic component is mounted, whereby a component is easily dropped due to vibration or a stress, which is problematic. When a solder is bridged between circuits, there occurs a critical defect that circuits are short-circuited. Under the present circumstances, some measures need to be taken since such a defect considerably deteriorates the reliability of a product.

Accordingly, an object of the present invention is to provide a highly reliable three-dimensional circuit board which can prevent solder flow or a short in a circuit during mounting of a component.

### MEANS FOR SOLVING THE PROBLEMS

The present invention is defined by the independent claims. Preferred embodiments are defined by the dependent claims. Further aspects are provided for facilitating the understanding of the invention. The present inventors intensively studied to resolve the above-described problems, and discovered that the above-described problems can be resolved by forming a solder resist such that a component mount unit of a three-dimensional board circuit is open, thereby completing the present invention.

Preferably, in the three-dimensional circuit board of the present invention, the solder resist is a photoresist. In the three-dimensional circuit board of the present invention, the three-dimensional board is a resin molding and a circuit is formed on the resin molding. Further, in the three-dimensional circuit board of the present invention, the resin molding is formed by dispersing a non-conductive metal complex in a resin for molding, a metal core is generated by irradiation of a laser beam after molding the resin molding, and plating is then performed to form the circuit. Still further, preferably, in the three-dimensional circuit board of the present invention, the solder resist is applied by a spraying method, and exposure of the solder resist is performed by irradiation of a focused light source.

### EFFECTS OF THE INVENTION

According to the present invention, a highly reliable three-dimensional circuit board which can prevent solder flow during component mounting or a short of a circuit can be provided.

### BRIEF DESCRIPTION OF THE DRAWINGS

Fig. 1 is a schematic perspective view of a three-dimensional circuit board in one preferred embodiment of the present invention.
Figs. 2(a) and (b) are an exploded view of the three-dimensional circuit board of Fig. 1 when cut along a line connecting an A point and a B point, (a) representing the outside of the three-dimensional circuit board, and (b) representing the inside of the three-dimensional circuit board.

### MODE FOR CARRYING OUT THE INVENTION

In the following, embodiments of the present invention will be described in detail.

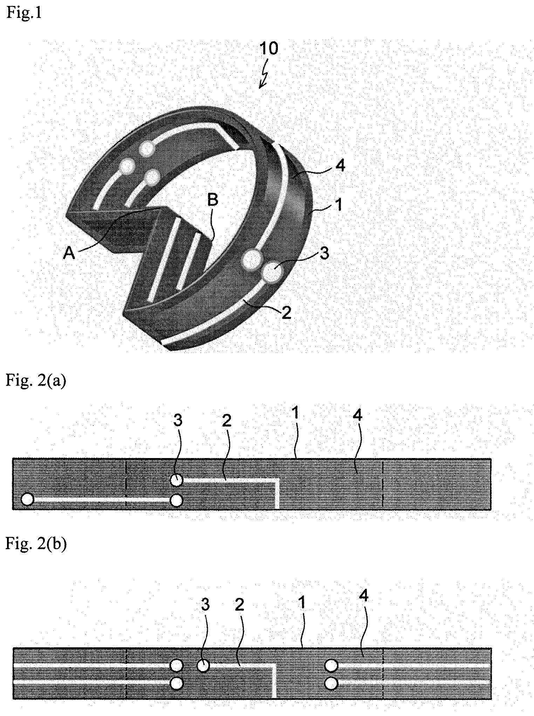

A three-dimensional circuit board of the present invention comprises a circuit formed on the three-dimensional board and a component mount unit. Fig. 1 is a schematic perspective view of a three-dimensional circuit board in one preferred embodiment of the present invention, and Figs. 2(a) and (b) are an exploded view of the three-dimensional circuit board of Fig. 1 when cut along a line connecting an A point and a B point, Fig. 2(a) representing the outside of the three-dimensional circuit board, and Fig. 2(b) representing the inside of the three-dimensional circuit board. In the illustrated example, in a three-dimensional circuit board 10 of the present invention, a circuit 2 is formed on a three-dimensional board 1, a solder resist 4 is formed on the three-dimensional board such that only a component mount unit 3 on which an electronic component is mounted is open, and an electronic component is mounted on the component mount unit 3 with a solder. By forming a solder resist 4 such that the component mount unit 3 is open, solder flow to the outside of an opening or a short of the circuit 2 can be prevented. In the three-dimensional circuit board of the present invention the component mount unit 3 is provided on a curved surface unit or a bend as illustrated.

### [Three-Dimensional Circuit Board]

A three-dimensional circuit board of the present invention can be manufactured by molding a three-dimensional board, forming a circuit on the three-dimensional board, and then, forming a solder resist such that the component mount unit is open. Examples of a molding material for the three-dimensional board include inorganic materials such as ceramic and organic materials using a resin.

As the inorganic materials, a silicon nitride sintered compact, a sialon sintered compact, a silicon carbide sintered compact, an alumina sintered compact, an aluminum nitride sintered compact, or the like can be preferably used. Other than such ceramics, a molded metal the surface of which is insulation-treated may be used.

As the organic material, a thermosetting resin and a thermoplastic resin may be preferably used. Examples of the thermosetting resin include an epoxy resin, a melamine resin, a phenol resin, a urea resin, and an unsaturated polyester resin. Examples of the thermoplastic resin include polyethylene, polypropylene, polystyrene, an ABS resin, a vinyl chloride resin, a methyl methacrylate resin, nylon, a polyester resin, a fluorocarbon resin, poly carbonate polyacetal, polyamide, polyphenylene ether, amorphous polyarylate, polysulfone, polyethersulfone, polyphenylene sulfide, polyetheretherketone, polyimide, polyetherimide, and a liquid crystal polymer.

In a three-dimensional circuit board of the present invention, preferably, a three-dimensional board is composed of a resin molding, wherein a circuit is formed on the resin molding, and a thermoplastic resin which is lightweight and easy to mold is desired to be used. In particular, since an electronic component is mounted on a three-dimensional circuit board of the present invention with a solder, fluorocarbon resin, poly carbonate polyacetal, polyamide, polyphenylene ether, amorphous polyarylate, polysulfone, polyethersulfone, polyphenylene sulfide, polyetheretherketone, polyimide, polyetherimide, or liquid crystal polymer which is called "engineering plastic" and is excellent in heat resistance is preferable.

In a three-dimensional circuit board of the present invention, for a method of forming a circuit on the surface of the three-dimensional board, a known method which may be appropriately selected depending on the purpose can be used. In particular, in a three-dimensional board circuit of the present invention, it is preferable that a non-conductive metal complex is dispersed in a resin for molding which is a material of a three-dimensional board, a three-dimensional board is molded by using the resin for molding, a metal core is generated by irradiation of a laser beam so as to match a circuit pattern, and plating is then performed to form a circuit.

The non-conductive metal complex which is used for forming a three-dimensional circuit board of the present invention is not particularly restricted. Examples of a central metal of the non-conductive metal complex include copper (Cu), nickel (Ni), palladium (Pd), silver (Ag), gold (Au), platinum (Pt), tin (Sn), iron (Fe), cobalt (Co), chromium (Cr), rhodium (Rh), and ruthenium (Ru). Examples of a ligand of the non-conductive metal complex include: organic carbonyl compounds such as a β-diketone such as acetyl acetone, benzoyl acetone, or dibenzoyl methane or a β-keto carboxylic acid ester such as acetoacetic acid ethyl; organic nitrogen compounds such as an organic nitrogen compound having a -N=N- bond, an organic nitrogen compound having a -C=N- bond and a OH bond, and an organic nitrogen compound having a -N< bond and a -OH bond; and organic sulfur compounds such as an organic sulfur compound having a >C=S bond, and an organic sulfur compound having a -C-SH bond.

A laser beam is not particularly restricted as long as a metal can be released by irradiating the above-described non-conductive metal complex with the laser beam. For the wavelength of the laser beam, for example, 248 nm, 308 nm, 355 nm, 532 nm, 1064 nm, and 10600 nm may be used.

For a plating which is performed on a metal core generated by a laser beam, a copper plating which is excellent in conductivity is preferable, by which a circuit is formed on a three-dimensional board. Such a copper plating may be performed by an electrolytic plating. Although a gold plating is desirably performed in order to secure reliability on the surface of a circuit for a long time, there is a problem that a gold plating costs a lot. In a three-dimensional circuit board of the present invention, however, since a circuit of the three-dimensional board is covered with a solder resist except for an opening which is a component mount unit, oxidation of the circuit can be prevented without performing a high cost gold plating, thereby obtaining reliability for a long time. In order to perform a gold plating on the surface of a circuit, first, an electroless plating of nickel is performed on a copper plating layer, and then, an electroless plating of gold is performed on the obtained nickel layer.

### [Solder Resist]

In a three-dimensional circuit board of the present invention, a solder resist is formed such that a component mount unit is open. Formation of a solder resist on the surface of a three-dimensional circuit board can be performed in the order, application of a solder resist composition, drying, exposure, development, and thermosetting. For a solder resist composition used for the formation of a solder resist, a solder resist composition containing a resin, a monomer, a photopolymerization initiator, a thermosetting component, or a filler can be used, and the composition thereof can be appropriately designed depending on the purpose.

For a resin of a solder resist composition, a resin including a carboxyl group is preferable. The presence of a carboxyl group makes a solder resist to have an alkali development property. From the viewpoint of photocurability or resistance to development, an ethylenically unsaturated bond in addition to a carboxyl group is preferably contained in a molecule. For a monomer used for a solder resist composition, a compound (photosensitive monomer) having one or more ethylenically unsaturated groups in the molecule is preferable. Such a monomer is photo-cured by irradiation of an active energy ray, making or serving to make a resin to be insoluble to an alkaline aqueous solution.

For a photopolymerization initiator, any known photopolymerization initiator can be used. Among others, an oxime ester-based photopolymerization initiator having an oxime ester group, an α-aminoacetophenone-based photopolymerization initiator, and an acylphosphine oxide-based photopolymerization initiator are preferable. A thermosetting component is a component for imparting a heat resistance, and a known conventional thermosetting resin such as a blocked isocyanate compound, an amino resin, a maleimide compound, a benzoxazine resin, a carbodiimide resin, a cyclocarbonate compound, a polyfunctional epoxy compound, a polyfunctional oxetane compound, an episulfide resin, melamine derivatives can be used. A filler is a component which is added as needed in order to increase the physical properties or the like of the obtained hardened material. For such a filler, a known inorganic or organic filler can be used. For example, sulfuric acid barium, spherical silica or talc, kaolin, or Sillitin can be used. Further, in order to obtain white appearance or flame retardancy, metal hydroxide such as titanium oxide, metal oxide, or aluminum hydroxide may be used also as an extender filler.

For a three-dimensional circuit board of the present invention, application of a solder resist composition is preferably performed by a spraying method. For a method of applying a solder resist composition of a printed wiring board which is a two-dimensional circuit board, screen printing is generally used. Roll coating, curtain coating, and roll laminate of a dry film can also be used. These methods, however, are not preferable due to many difficulties for a three-dimensional circuit board which is three-dimensional. Application of a solder resist composition by a spraying method is particularly effective when a component is mounted on a curved surface of a three-dimensional circuit board, in other words, when an opening is provided on a curved surface of a three-dimensional circuit board. When a three-dimensional circuit board is formed by using a dry film, it may be formed by in-molding.

Drying of a solder resist composition is performed by volatilizing a solvent in the composition to solidify the composition as a solder resist. Since drying of a solder resist composition is attained when a solvent is volatilized, a drying method is not particularly limited, although a temperature as high as a solder resist undergoes a hardening reaction is not preferable. Usually, drying may be performed in a warm air drying furnace at 80°C for about 30 minutes.

A solder resist composition is exposed to a light for the purpose of performing patterning using a photo-reaction. A pattern such that a portion other than a component mount portion is covered is used. When a three-dimensional circuit board of the present invention is formed, a solder resist composition is preferably exposed by irradiation of a focused light source. For example, a method of irradiation in which a light source mainly including i-line is focused is preferable. Exposure of a two-dimensional printed wiring board is performed by using a full-scale photomask or performed by projection using a dry plate. Such methods are difficult to apply and not preferable for a three-dimensional circuit board which is three-dimensional. A light source may be focused by any known method.

Development of a solder resist composition is performed for the purpose of removing an unwanted portion of a pattern which has been photo-reacted by exposure. A developer may be selected depending on a solder resist composition. When a solder resist composition is an alkali development type, an aqueous solution of various organic amines such as sodium carbonate, sodium hydroxide, or potassium hydroxide, or the like may be used. When a solder resist composition is a solvent development type, a designated solvent may be used.

Thermosetting of a solder resist composition is performed for the purpose of generating a hardening reaction of a solder resist composition by heat to obtain heat resistance, solvent resistance, or the like. Thermosetting of a solder resist composition may be performed without exceeding the heat resistance of a molding material of a three-dimensional board. For example, thermosetting is preferably performed in an oven at 150°C for about 30 minutes. From the viewpoint of thermosetting of a solder resist composition, a molding material of a three-dimensional board is desirably an engineering plastic which has high heat resistance.

In a three-dimensional circuit board of the present invention, a solder resist composition is not particularly limited, and any known solder resist composition may be used. A positive type photo solder resist composition is preferably used. In general, a negative type solder resist composition is used for a two-dimensional printed wiring board, and a positive type solder resist composition is preferably used for a three-dimensional circuit board which is three-dimensional. This is because, in a three-dimensional circuit board of the present invention, the size of an opening of a solder resist, which may be about the size of a mounted component, accounts for little in terms of whole area of the circuit board. In other words, since a positive type solder resist composition has a mechanism in which an exposed portion is dissolved in development in a post-process, light irradiation is applied only to an opening of a component mount portion, thereby shortening the process.

When a three-dimensional circuit board of the present invention is manufactured by using a positive type solder resist, an advantageous result is obtained in a high-temperature and high-humidity test (HAST: Highly Accelerated Stress Test). A HAST, which is performed in an environment at higher than 100°C at high humidity, is employed recently in many cases since a reliable test can be performed in a short time, although in some cases the test does not have correlation with actual failures. It is known that, usually, in a HAST, a circuit board on which a solder resist is formed has a reduced insulation resistance value and often suffers migration. This is thought to be because, while, when a solder resist is not formed, a circuit is oxidized and migration is less likely to occur, when a solder resist is formed, for example, the presence of the solder resist covering the surface of the circuit prevents a gas generated from a circuit board due to a strict test environment from escaping, or entrance of water in the solder resist due to humidification at a high pressure causes migration. However, when a solder resist is formed on a three-dimensional circuit board with a positive type solder resist composition, a different behavior is observed, and time to failure can be prolonged while suppressing oxidation of the circuit.

For a three-dimensional circuit board of the present invention, it is important only that a solder resist is formed such that a component mount unit of a three-dimensional circuit board comprising a circuit formed on the three-dimensional board and a component mount unit is open, and an electronic component is mounted on the component mount unit with solder. A configuration other than the above is not particularly limited. For example, on a three-dimensional circuit board of the present invention, various electronic components such as an IC, an LED, a camera, or a microphone can be mounted.

### EXAMPLES

In the following a three-dimensional circuit board of the present invention will be described in detail by way of Examples.

### < Manufacturing Example 1 of Three-Dimensional Circuit Board >

In order to manufacture a three-dimensional circuit board illustrated in Fig. 1, VICTREX PEEK 450 G 903 Blk manufactured by Victrex-MC Inc. was injection-molded, and a portion other than a circuit formation portion was masked with a water-resistant and solvent-resistant masking tape. In order to improve the adherence of a circuit, the circuit board was washed with 10% by mass of sulfuric acid aqueous solution, and then washed with methylene chloride containing 1% silane coupling agent. Subsequently, a silver filler-based normal temperature drying type conductive coating was applied to the circuit board by spraying and dried, and the masking tape was then peeled off, followed by electrolytic copper plating and nickel-based electroless gold plating.

### < Manufacturing Example 2 of Three-Dimensional Circuit Board >

A three-dimensional circuit board was manufactured in a similar manner to Manufacturing Example 1 of a three-dimensional circuit board except that nickel-based electroless gold plating was not performed.

### < Manufacturing Example 3 of Three-Dimensional Circuit Board >

In order to manufacture a three-dimensional circuit board illustrated in Fig. 1, Ultramid T 4381 LDS manufactured by BASF Corporation which is a compound obtained by mixing and dispersing a resin and a laser-reactive non-conductive metal complex was injection-molded, and a circuit formation portion was irradiated with a laser beam having a wavelength of 1064 nm to roughen the surface as well as to metalize the non-conductive metal complex. Next, electrolytic copper plating and nickel-based electroless gold plating were performed to manufacture a three-dimensional circuit board.

### < Manufacturing Example 4 of Three-Dimensional Circuit Board >

A three-dimensional circuit board was manufactured in a similar manner to Manufacturing Example 3 of a three-dimensional circuit board except that nickel-based electroless gold plating was not performed.

### < Preparation of Positive Type Solder Resist Composition >

To 200 parts by mass of a varnish (solid content 50%) obtained by dissolving a phenol resin HF-4M manufactured by Meiwa Plastic Industries, Ltd. in carbitol acetate, 20 parts by mass of NQD ester NT-200 (an ester compound of 1,2-naphthoquinone-(2)-diazido-4-sulfonic acid and 2,3,4-tribenzophenone) manufactured by Toyo Gosei Co., Ltd. was added, and 10 parts by mass of an epoxy compound TEPIC-H manufactured by Nissan Chemical Industries, Ltd. was added. This mixture was dispersed by a triple roll mill and diluted with carbitol acetate to reach a viscosity such that the mixture can be applied by spraying.

### < Preparation of Negative Type Solder Resist Composition >

Into a flask comprising a thermometer, a stirrer, a dropping funnel, and a reflux condenser, 210 g of an epoxy cresol novolac resin (an epoxy equivalent of 200 to 220 and a softening point of 80 to 90°C) and 96.4 g of carbitol acetate as a solvent were added, followed by heat dissolution. Subsequently, to this mixture, 0.1 g of hydroquinone as a polymerization inhibitor and 2.0 g of triphenylphosphine as a reaction catalyst were added. This mixture was heated to 95 to 105°C, 72 g of acrylic acid was gradually added dropwise, and the mixture was allowed to react for about 16 hours until the acid value reaches 3.0 mgKOH/g or smaller. After cooling the reaction product to 80 to 90°C, 76.1 g of tetrahydrophthalic anhydride was added thereto, and the mixture was allowed to react for about six hours until an absorption peak (1780 cm⁻¹) of an acid anhydride disappeared in an infrared absorption analysis. The reaction solution was diluted by adding 96.4 g of an aromatic solvent IPSOL #150 manufactured by Idemitsu Kosan Co., Ltd. thereto, and the resultant solution was taken out. The thus obtained photosensitive polymer solution containing a carboxyl group has a non-volatile content of 65% by weight and an acid value of the solid content of 78 mgKOH/g.

To 154 parts by mass of the obtained photosensitive polymer solution containing a carboxyl group, 15 parts by mass of 2-methyl-1-(4-methylthiophenyl)-2-morpholino propane-1-one, 2 parts by mass of phthalocyanine green, 160 parts by mass of sulfuric acid barium, 6 parts by mass of dipentaerythritol hexaacrylate, 5 parts by mass of melamine, 0.5 parts by mass of dicyandiamide, 25 parts by mass of phenol novolac epoxy resin (an epoxy equivalent of 200 to 220 and a softening point of 80 to 90°C) varnish (epoxy : carbitol acetate = 70 : 30), and 14 parts by mass of β-triglycidylisocyanurate having a structure in which epoxy groups are bonded in one direction with respect to the plane of an S-triazine skeleton were added. This mixture was dispersed by a triple roll mill to obtain a negative type solder resist composition. The composition was diluted by propylene glycol monomethyl ether acetate to reach a viscosity such that the composition can be applied by spraying.

### < Examples 1 to 4 >

To the three-dimensional circuit board manufactured in the Manufacturing Examples 1 to 4 of a three-dimensional circuit board, a positive type solder resist composition which was manufactured in the preparation of a positive type solder resist composition was applied by spraying such that the film thickness after drying was 5 to 10 µm. This was dried in a hot air drying furnace at 80°C for 30 minutes to volatilize a solvent, followed by focusing a light source mainly including i-line and exposing a component mount unit in an integrated amount of light of 300 mJ/cm². Subsequently, development was performed with 0.3% sodium hydroxide aqueous solution to remove a solder resist composition on the exposed portion. A solder resist composition was then thermoset in an oven at 150°C for 30 minutes to form a solder resist on the three-dimensional circuit board.

### < Examples 5 to 8 >

To the three-dimensional circuit board manufactured in the Manufacturing Examples 1 to 4, a negative type solder resist composition which was manufactured in the preparation of a negative type solder resist composition was applied. This was dried in a hot air drying furnace at 80°C for 30 minutes to volatilize a solvent, followed by focusing a light source mainly including i-line and exposing a portion other than a component mount unit in an integrated amount of light of 300 mJ/cm². Subsequently, development was performed with 1% sodium carbonate aqueous solution to remove a solder resist on the unexposed portion. A solder resist was then thermoset in an oven at 150°C for 30 minutes to obtain a three-dimensional circuit board on which a solder resist was formed.

To the component mount unit of the obtained four types of three-dimensional circuit boards on which each solder resist of Examples 1 to 8 was formed, a cream solder was applied, and electronic components were placed, followed by heating in a reflow furnace at 280°C for 20 seconds, thereby mounting the electronic components. Ten electronic components were mounted on each three-dimensional circuit board.

### < Comparative Example 1 to 4 >

Electronic components were mounted on the three-dimensional circuit board manufactured in Manufacturing Examples 1 to 4 of a three-dimensional circuit board in a similar manner as described above without forming a solder resist to manufacture four types (Comparative Example 1 to 4) of three-dimensional circuit boards.

A solder flow, a short, and a high-temperature and high-humidity test (HAST) of each three-dimensional circuit board on which electronic components were mounted were evaluated. The evaluation method is as follows.

### < Solder Flow >

A solder flow was evaluated by determining whether solder flowed along a wiring from a mounted portion or not by visually inspecting the appearance. The following evaluation criteria were used: no solder flow from a mounted portion was observed for all ten samples: ⊚, a solder flow was observed in one to three samples: o, a solder flow was observed in four to nine samples: △, and a solder flow was observed in all samples: ×. The results are listed on Tables 1 to 3.

### < Short >

A short was evaluated by determining whether a solder used during mounting was bridged between adjacent wirings or not by visually inspecting the appearance. The following evaluation criteria were used: no short was observed for all ten samples: o, a short was observed for one or two samples: △, and a short was observed for three or more samples: ×. The results are listed on Tables 1 to 3.

### < High-Temperature and High-Humidity Test >

A high-temperature and high-humidity test was evaluated by selecting a sample not having a short one by one, leaving the sample in an environment at 85°C at 85%RH for 500 hours, and visually inspecting the degree of discoloration of a wiring. The following evaluation criteria were used: no discoloration of a wiring was observed: ⊚, some discoloration of a wiring was observed: o, discoloration of a wiring was clearly confirmed: △, and severe discoloration of a wiring was observed: ×. The results are listed on Tables 1 to 3.

**[Table 1]**

| | Example 1 | Example 2 | Example 3 | Example 4 |
|---|---|---|---|---|
| Three-Dimensional Circuit Board | Manufacturing Example 1 | Manufacturing Example 2 | Manufacturing Example 3 | Manufacturing Example 4 |
| Solder Resist | Positive Type | Positive Type | Positive Type | Positive Type |
| Solder Flow | ⊚ | ⊚ | ⊚ | ⊚ |
| Short | ○ | ○ | ○ | ○ |
| High-Temperature and High-Humidity Test | ⊚ | ○ | ⊚ | ⊚ |

**[Table 2]**

| | Example 5 | Example 6 | Example 7 | Example 8 |
|---|---|---|---|---|
| Three-Dimensional Circuit Board | Manufacturing Example 1 | Manufacturing Example 2 | Manufacturing Example 3 | Manufacturing Example 4 |
| Solder Resist | Negative Type | Negative Type | Negative Type | Negative Type |
| Solder Flow | ⊚ | ⊚ | ⊚ | ⊚ |
| Short | ○ | ○ | ○ | ○ |
| High-Temperature and High-Humidity Test | ⊚ | ○ | ⊚ | ⊚ |

**[Table 3]**

| | Comparative Example 1 | Comparative Example 2 | Comparative Example 3 | Comparative Example 4 |
|---|---|---|---|---|
| Three-Dimensional Circuit Board | Manufacturing Example 1 | Manufacturing Example 2 | Manufacturing Example 3 | Manufacturing Example 4 |
| Solder Resist | None | None | None | None |
| Solder Flow | × | × | × | × |
| Short | × | × | △ | △ |
| High-Temperature and High-Humidity Test | ⊚ | × | ⊚ | × |

### <HAST>

An extent to which a HAST influenced on a three-dimensional circuit board was examined. On a three-dimensional circuit board of Manufacturing Example 4 of a three-dimensional circuit board, in Reference Example 1, a solder resist was formed with a positive type solder resist composition and a component was not mounted; in Reference Example 2, a solder resist was formed with a negative type solder resist composition; and in Reference Example 3, a solder resist was not formed. To each three-dimensional circuit board of Reference Examples 1 to 3, a voltage of 10 V was applied, and a test was performed in an environment at 120°C at 85%RH. Each sample was once taken out 100 hours after the start of the test to observe the occurrence of migration with microscope, and to evaluate oxidation of a wiring by visually inspecting the color change.

The following evaluation criteria were used: occurrence of migration was not observed at all: o, some occurrence of migration was observed: △, occurrence of migration was clearly observed: ×, and severe migration occurred, which was close to a short: ××. Regarding oxidation of a wiring, discoloration was not observed: o, some discoloration was observed: △, and discoloration was clearly observed: ×. A test was continued after the observation to determine that the board had a failure when the insulation resistance value was 100 MΩ or smaller, and a test time to the failure was measured. The results are listed on Table 4.

**[Table 4]**

| | Reference Example 1 | Reference Example 2 | Reference Example 3 |
|---|---|---|---|
| Occurrence of Migration | ○ | △ | ○ |
| Discoloration of Wiring | ○ | ○ | × |
| Time to Failure | 600 hours | 300 hours | 450 hours |

Table 4 shows that, in a HAST which is disadvantageous with the presence of a solder resist, occurrence of migration was suppressed while suppressing discoloration of a wiring due to oxidation in a three-dimensional circuit board on which a solder resist was formed with a positive type solder resist composition, and time to failure of the three-dimensional circuit board was longer than that of a three-dimensional circuit board on which a solder resist was not formed.

Consequently, it is found that a three-dimensional circuit board of the present invention does not cause a solder flow which degrades the reliability and a short which is a critical failure in which a solder is bridged between circuits even if a component is mounted, and a wiring is not oxidized for a long time, thereby maintaining the performance. It is also found that use of a positive type solder resist composition for a three-dimensional circuit board is advantageous also in a HAST.

### DESCRIPTION OF SYMBOLS

- 1: three-dimensional board
- 2: circuit
- 3: component mount unit
- 4: solder resist
- 10: three-dimensional circuit board

## Claims

1. A three-dimensional circuit board (10) comprising a circuit (2) formed on a three-dimensional board (1), wherein:
a component mount unit (3) being provided on a curved surface unit or a bend,
a solder resist (4) which is formed such that an opening is provided at the component mount unit (3),
an electronic component which is mounted on the component mount unit (3) with solder,
**characterized in that**
the three-dimensional board (1) is a resin molding and a circuit (2) is formed on the resin molding, and
the resin molding is formed by dispersing a non-conductive metal complex in a resin for molding, a metal core is generated by irradiation of a laser beam after molding the resin molding, and plating is then performed to form the circuit (2).

2. The three-dimensional circuit board (10) according to claim 1, wherein the solder resist (4) is a photoresist.

3. The three-dimensional circuit board (10) according to claim 1 or 2, wherein the solder resist (4) is applied by a spraying method, and exposure of the solder resist (4) is performed by irradiation of a focused light source.

4. A method of forming a three-dimensional circuit board (10) comprising a circuit (2) formed on a three-dimensional board (1), wherein:
a component mount unit (3) is provided on a curved surface unit or a bend, and
a solder resist (4) is formed onto said three-dimensional circuit board (10) comprising a circuit (2), so that an opening is provided at the component mount unit (3) and an electronic component is mounted on the component mount unit (3) with a solder,
**characterized in that**
the solder resist is formed by thermosetting the solder resist composition on said three-dimensional circuit board (10), wherein
the solder resist comprises a hardened material of the solder resist composition,
the three-dimensional board (1) is a resin molding and a circuit (2) is formed on the resin molding, and
the resin molding is formed by dispersing a non-conductive metal complex in a resin for molding, a metal core is generated by irradiation of a laser beam after molding the resin molding, and plating is then performed to form the circuit (2).

## Patentansprüche

1. Dreidimensionale Leiterplatte (10), umfassend eine Schaltung (2), die auf einer dreidimensionalen Platine (1) gebildet ist, wobei:
eine Komponentenmontageeinheit (3) an einer gekrümmten Oberflächeneinheit oder einer Biegung bereitgestellt ist,
einen Lötstopplack (4), der so gebildet ist, dass eine Öffnung an der Komponentenmontageeinheit (3) bereitgestellt wird,
eine elektronische Komponente, die mit Lötmetall auf der Komponentenmontageeinheit (3) montiert ist,
**dadurch gekennzeichnet, dass**
die dreidimensionale Platine (1) ein Harzformteil ist und eine Schaltung (2) auf dem Harzformteil gebildet ist, und
das Harzformteil durch Dispergieren eines nichtleitenden Metallkomplexes in einem Harz zum Formen gebildet wird, wobei durch Bestrahlung eines Laserstrahls nach Formen des Harzformteils ein Metallkern erzeugt wird und danach Überziehen durchgeführt wird, um die Schaltung (2) zu bilden.

2. Dreidimensionale Leiterplatte (10) nach Anspruch 1, wobei der Lötstopplack (4) ein Fotolack ist.

3. Dreidimensionale Leiterplatte (10) nach Anspruch 1 oder 2, wobei der Lötstopplack (4) durch ein Sprühverfahren aufgetragen wird und Belichten des Lötstopplacks (4) durch Bestrahlung mit einer gebündelten Lichtquelle durchgeführt wird.

4. Verfahren zum Bilden einer dreidimensionalen Leiterplatte (10), umfassend eine Schaltung (2), die auf einer dreidimensionalen Platine (1) gebildet ist, wobei:
eine Komponentenmontageeinheit (3) an einer gekrümmten Oberflächeneinheit oder einer Biegung bereitgestellt ist, und
ein Lötstopplack (4) auf der dreidimensionalen Leiterplatte (10), die eine Schaltung (2) umfasst, so gebildet wird, dass eine Öffnung an der Komponentenmontageeinheit (3) bereitgestellt wird und eine elektronische Komponente mit einem Lötmetall auf der Komponentenmontageeinheit (3) montiert wird,
**dadurch gekennzeichnet, dass**
der Lötstopplack durch Warmaushärtung der Lötstopplackzusammensetzung auf der dreidimensionalen Leiterplatte (10) gebildet wird, wobei
der Lötstopplack ein ausgehärtetes Material der Lötstopplackzusammensetzung umfasst,
die dreidimensionale Platine (1) ein Harzformteil ist und eine Schaltung (2) auf dem Harzformteil gebildet ist, und
das Harzformteil durch Dispergieren eines nichtleitenden Metallkomplexes in einem Harz zum Formen gebildet wird, wobei durch Bestrahlung eines Laserstrahls nach Formen des Harzformteils ein Metallkern erzeugt wird und danach Überziehen durchgeführt wird, um die Schaltung (2) zu bilden.

## Revendications

1. Carte à circuit imprimé tridimensionnelle (10) comprenant un circuit (2) formé sur une carte tridimensionnelle (1), dans laquelle :
une unité de montage de composant (3) est disposée sur une unité de surface incurvée ou un coude,
une épargne de soudage (4) est formée de sorte qu'une ouverture soit disposée au niveau de l'unité de montage de composant (3),
un composant électronique est monté sur l'unité de montage de composant (3) avec une soudure,
**caractérisée en ce que**
la carte tridimensionnelle (1) est un moulage de résine et un circuit (2) est formé sur le moulage de résine, et
le moulage de résine est formé en dispersant un complexe métallique non conducteur dans une résine pour le moulage, un noyau métallique est généré par irradiation d'un faisceau laser après le moulage du moulage de résine, et un placage est ensuite réalisé pour former le circuit (2).

2. Carte à circuit imprimé tridimensionnelle (10) selon la revendication 1, dans laquelle la résistance de soudage (4) est une photorésistance.

3. Carte à circuit imprimé tridimensionnelle (10) selon la revendication 1 ou la revendication 2, dans laquelle l'épargne de soudage (4) est appliquée par un procédé de pulvérisation, et une exposition de l'épargne de soudage (4) est mise en oeuvre par irradiation d'une source de lumière focalisée.

4. Procédé de formation d'une carte à circuit imprimé tridimensionnelle (10) comprenant un circuit (2) formé sur une carte tridimensionnelle (1), dans lequel :
une unité de montage de composant (3) est disposée sur une unité de surface incurvée ou un coude, et
une épargne de soudage (4) est formée sur ladite carte à circuit imprimé tridimensionnelle (10) comprenant un circuit (2), de sorte qu'une ouverture soit disposée au niveau de l'unité de montage de composant (3) et qu'un composant électrique soit monté sur l'unité de montage de composant (3) avec une soudure,
**caractérisé en ce que**
l'épargne de soudage est formée par thermofixation de la composition d'épargne de soudage sur ladite carte à circuit imprimé tridimensionnelle (10), dans lequel
l'épargne de soudage comprend un matériau durci de la composition d'épargne de soudage,
la carte tridimensionnelle (1) est un moulage de résine et un circuit (2) est formé sur le moulage de résine, et
le moulage de résine est formé en dispersant un complexe métallique non conducteur dans une résine pour le moulage, un noyau métallique est généré par irradiation d'un faisceau laser après le moulage du moulage de résine, et un placage est ensuite mis en oeuvre pour former le circuit (2).
